# EUROPÄISCHE PATENTANMELDUNG

(11) **EP 4 339 140 A1**
(43) Veröffentlichungstag der Anmeldung: **20.03.2024**
(21) Anmeldenummer: 22195682.4
(22) Anmeldetag: 14.09.2022
(51) Int. Cl.: B65G 54/02, B60L 13/00

(54) **ANORDNUNG, WEICHE, VERFAHREN, COMPUTERSYSTEM, COMPUTERPROGRAMMPRODUKT**

(71) Anmelder: Siemens Aktiengesellschaft, 80333 München (DE)
(72) Erfinder: Cramer, Christian, 90431 Nürnberg (DE); Groth, Klaus, 91217 Hersbruck (DE); Kunze, Philipp, 90489 Nürnberg (DE); Streubühr, Martin, 90513 Zirndorf (DE)
(74) Vertreter: Siemens Patent Attorneys

(57) **Zusammenfassung**

Die Erfindung betrifft eine Anordnung (ARR) umfassend
ein Führungssystem (GDS), ein Trägerfahrzeug (VHC), wobei das Führungssystem (GDS) eine sich entlang eines Fahrweges (PTH) erstreckende Streckenführung (GDE) für das Trägerfahrzeug (VHC) aufweist. Um einen flexiblen und raschen Materialfluss in einer Produktion zu gewährleisten, wird vorgeschlagen, dass das Führungssystem (GDS) an dem Trägerfahrzeug (VHC) Fahrzeugführungselemente (GVE) aufweist, das Führungssystem (GDS) an dem Trägerfahrzeug (VHC) Fahrzeugführungselemente (GVE) aufweist, wobei das Führungssystem (GDS) derart ausgebildet ist, dass
- eine Führungsfunktion (GFC) des Führungssystems (GDS) den Freiheitsgrad der translatorischen Beweglichkeit des Trägerfahrzeugs (VHC) beim Zusammenwirken der Streckenführung (GDE) mit den Fahrzeugführungselementen (GVE) bis auf ein begrenztes Bewegungsspiel auf eine translatorische Beweglichkeit entlang des Fahrweges (PTH) einschränkt,
- die Führungsfunktion (GFC) zumindest abschnittsweise entlang des Fahrweges (PTH)
(a) aufgehoben werden kann mittels einer Beweglichkeit der Fahrzeugführungselemente (GVE) und/oder der Streckenführung (GDE) aus einer Führungsposition heraus und
(b) aktiviert werden kann mittels einer Beweglichkeit der Fahrzeugführungselemente (GVE) oder der Streckenführung (GDE) in die Führungsposition hinein.

## Beschreibung

Die Erfindung betrifft eine Anordnung umfassend ein Führungssystem, ein Trägerfahrzeug, wobei das Führungssystem eine sich entlang eines Fahrweges erstreckende Streckenführung für das Trägerfahrzeug aufweist.

In Produktionsanlagen wird neben Durchsatz zunehmend Wert auf Flexibilität und Individualisierung gelegt. Dies setzt ein flexibles Maschinenlayout voraus bei dem Materialflüsse getrennt und zusammengeführt werden, um individuelle, aber auch parallele Bearbeitungen zu ermöglichen. Im Kontext von Führungssystem, insbesondere umfassend Linearmotorsysteme, muss dabei vor allem auf die Prozessgeschwindigkeit geachtet werden.

An Bearbeitungsstationen können große Prozesskräfte entstehen und sind hohe Wiederholgenauigkeiten notwendig. Das stellt hohe Anforderungen an die Führungssysteme. Hier sind Linearmotoren mit präziser und steifer mechanischer Führung im Vorteil welche auch Stand der Technik sind. Steife mechanische Führungen haben die Eigenschaft, dass diese durchgehend über das komplette Linearmotorsystem montiert sind und aus unflexiblen Materialien bestehen. Auf steifen Führungen ist das Trennen und Zusammenführen von Materialflüssen nur durch eine erhebliche Verringerung der Prozessgeschwindigkeit möglich.

Einerseits kann das Problem durch eine klassische Weitergabe von Produkten über ein Handlingsgerät wie einen Picker oder über einfachere Mechaniken gelöst werden. Dieses Verfahren weist nachteilhaft eine geringe Prozessgeschwindigkeit auf.

Eine andere Möglichkeit ist die Übergabevorrichtung als Haltevorrichtung auf dem Trägerfahrzeug zu konzipieren oder durch Einklemmen des Produkts zwischen Trägerfahrzeugen von einem Linearmotorsystem auf ein anderes Linearmotorsystem zu übergeben. Hierbei arbeiten beide Linearmotorsysteme völlig getrennt voneinander. Das limitiert jedoch die Möglichkeiten der Befestigung des Produkts auf dem Trägerfahrzeug und setzt eine gewisse Mindestgröße und Beschaffenheit des Produkts voraus. Beispielsweise darf das Produkt nicht aus einem flexiblen Material (z.B. Schaumstoff) bestehen.

Ein Beispiel für ein derartiges Übergeben der Produkte zeigt die Anlage mit dem Markennamen "Beckhoff XTS" der Firma Beckhoff Automation GmbH & Co. KG (siehe zum Beispiel unter: https://www.beckhoff.com/de-de/produkte/motion/xts-linearerprodukttransport/).

Die Firma B&R Industrial Automation GmbH bietet ein flexibles Gleissystem an mit der Bezeichnung "Acopostrak" umfassend eine rein elektro-magnetisch arbeitende Hochgeschwindigkeitsweiche, mit der Produktströme bei voller Geschwindigkeit getrennt und wieder zusammengeführt werden können (https://www.br-automation.com/en/products/mechatronic-systems/acopostrak/). Zwei Linearmotorstrecken werden hierbei genüberliegend angebracht. Soll ein Trägerfahrzeug die Strecke wechseln wird auf einer Seite ein Magnetfeld-schwächender Strom und auf der anderen Seite ein feldstärkender Strom eingeprägt. Das Trägerfahrzeug (Carrier) wird somit magnetisch auf die andere Seite gezogen.

Der Erfindung liegt die Aufgabe zugrunde, eine effiziente, rasche und präzise Handhabung von Materialien und Werkstücken in einer Produktionsanlage zu ermöglichen.

Die Erfindung löst die gestellte Aufgabe, mittels einer Anordnung der eingangs definierten Art mit den zusätzlichen kennzeichnenden Merkmalen des Anspruchs 1.

Im Einzelnen ist vorgesehen, dass das Führungssystem derart ausgebildet ist, dass
- eine Führungsfunktion des Führungssystems den Freiheitsgrad der translatorischen Beweglichkeit des Trägerfahrzeugs beim Zusammenwirken der Streckenführung mit den Fahrzeugführungselementen bis auf ein begrenztes Bewegungsspiel auf eine translatorische Beweglichkeit entlang des Fahrweges einschränkt,
- die Führungsfunktion zumindest abschnittsweise entlang des Fahrweges
   (a) aufgehoben werden kann mittels einer Beweglichkeit der Fahrzeugführungselemente und/oder der Streckenführung aus einer Führungsposition heraus und
   (b) aktiviert werden kann mittels einer Beweglichkeit der Fahrzeugführungselemente oder der Streckenführung in die Führungsposition hinein.

Eine Anordnung nach der Erfindung ist insbesondere eine Anordnung einer Produktionsanlage. Eine derartige Produktionsanlage kann beispielsweise eine integrierte automatisierte Material- oder Werkstücklogistik aufweisen, die auf Basis der Anordnung nach der Erfindung arbeitet. Die Anordnung nach der Erfindung kann mehrfach in einer solchen Produktionsanlage vorkommen, wobei bevorzugt eine Vielzahl von Trägerfahrzeugen jeweils einzelne oder mehrere Werkstücke oder Materialien transportieren. Eine Weiche ermöglicht es hierbei die transportierten Ströme zu teilen oder zu vereinen.

Eine erfindungsgemäße Anordnung lässt sich flexibel einsetzen und ermöglicht eine effiziente, rasche und präzise Handhabung der Werkstücke auch bei Losgrößen von 1.

Trägerfahrzeuge im Sinne der Erfindung werden auch häufig als Carrier oder Werkstückträger bezeichnet und sind zum automatischen Transport von Materialien oder Werkstücken in einer Produktionsanlage vorgesehen. Diese Trägerfahrzeuge müssen keinen eigenen Antrieb aufweisen, sondern können bevorzugt auch im Zusammenwirken mit einer Strecke oder einem Führungssystem Vortriebskräfte entwickeln.

Eine bevorzugte Weiterbildung der Anordnung sieht vor, dass entlang des Fahrweges eine Linearmotorstrecke ausgebildet ist, die mit an dem Trägerfahrzeug angebrachten Magneten magnetisch wechselwirkt, so dass dadurch das Trägerfahrzeug entlang des Fahrweges antreibbar ist.

Eine vorteilhafte Weiterbildung der Erfindung sieht vor, dass die Fahrzeugführungselemente mindestens eine, bevorzugt zwei oder besonders bevorzugt mindestens vier Rollen aufweisen und die Streckenführung mindestens eine, bevorzugt zwei Schienen aufweist, wobei die jede Schiene mit mindestens einer Rolle zusammenwirkt. Die Rollen sind bevorzugt mit den Schienen derart gestaltet und gepaart, dass eine Bewegung quer zur Fahrtrichtung eingeschränkt ist. Besonders bevorzugt ist die Form der Rolle derart auf die Form der Schiene jeweils abgestimmt, dass die Rolle von der Schiene quer zur Fahrtrichtung nur in einem Winkelfenster von höchstens 90° entlang einer Fortnahmerichtung entfernt werden kann. Bei beispielsweise einer Verwendung von zwei Schienen pro Führungssystem entlang eines Fahrweges eines Trägerfahrzeuges sind die Schienen bevorzugt derart angeordnet, dass bei aktivierter Führungsfunktion die jeweilige Entfernungsrichtung des Trägerfahrzeuges von den Schienen blockiert ist. Gemäß einer vorteilhaften Weiterbildung können die bevorzugt zwei Schienen hinsichtlich des Winkelfensters der jeweiligen Fortnahmerichtungen entgegengesetzt angeordnet sein, so dass der für die Fortnahme erforderliche Freiheitsgrad bei aktivierter Führungsfunktion blockiert ist.

Gemäß einer vorteilhaften Weiterbildung können die Aktivierung oder Aufhebung der Führungsfunktion mittels einer Beweglichkeit der Streckenführung erfolgen. Hierzu ist es bevorzugt, dass die Streckenführung translatorisch von dem jeweiligen Fahrzeugführungselement - bevorzugt streckenabschnittsweise - zur Aufhebung entfernt werden bzw. zur Aktivierung angenähert werden. Diese Bewegung kann bevorzugt mit einem elektromagnetischen Aktuator angetrieben sein. Alternativ ist auch ein pneumatischer oder hydraulischer Antrieb möglich.

Gemäß einer vorteilhaften Weiterbildung können die Schienen eine zu den Rollen im Querschnitt konkave Kontaktfläche aufweisen und die Rollen eine entsprechend konvexe Kontaktfläche, so dass sich eine Einschränkung des Winkelbereichs der möglichen Fortnahmerichtungen ergibt. Eine umgekehrte Formgebung bezüglich des Schienenquerschnitts und des Rollenquerschnitts ist hierbei jeweils auch möglich.

Um eine Übergabe zwischen verschiedenen Fahrwegen, die bevorzugt als Linearmotorstrecken ausgebildet sind, zu ermöglichen, kann vorteilhaft ein gemeinsamer überlappender paralleler Bereich der Fahrwege vorgesehen sein. Der wird vorliegend auch als Weiche oder Weichenabschnitt bezeichnet. Eine Weiche mit einer Anordnung nach der Erfindung oder einer Weiterbildung der Erfindung, sieht vor, dass das Führungssystem eine sich entlang eines ersten Fahrweges erstreckende erste Streckenführung und eine sich entlang eines zweiten Fahrweges erstreckende zweite Streckenführung für das Trägerfahrzeug aufweist. Dabei ist es zweckmäßig, wenn das Trägerfahrzeug erste Fahrzeugführungselemente für die erste Streckenführungen und zweite Fahrzeugführungselemente für die zweite Streckenführung aufweist, wobei die beiden Streckenführungen und Fahrzeugführungselemente derart angeordnet sind, dass die Fahrwege des Trägerfahrzeugs entlang eines Weichenabschnitts gleich sind.

Die Fahrwege, insbesondere die an der Weiche beteiligten Fahrwege, weisen bevorzugt ein mechanisches Führungssystem auf.

Kennzeichen des überlappenden Bereiches mit zwei Strecken - kurz Weiche - ist, dass das Trägerfahrzeug bei beiden mechanischen Führungssystemen im Eingriff sein kann und dauerhaft bei mindestens einem Führungssystem im Eingriff sein muss. Zeitweise kann das Trägerfahrzeug auch bei beiden Führungssystemen gleichzeitig im Eingriff sein.

Im Einzelnen sieht ein Verfahren zur Übergabe eines Trägerfahrzeug mittels einer Anordnung oder einer Weiche nach der Erfindung oder einer Weiterbildung der Erfindung vor, dass von einer ersten Streckenführung entlang eines ersten Fahrwegs an eine zweite Streckenführung entlang eines zweiten Fahrweges das Trägerfahrzeug übergeben wird. Während der Übergabe ist stets die Führungsfunktion entweder mittels der ersten Fahrzeugführungselemente an der ersten Streckenführung oder mittels der zweiten Fahrzeugführungselemente an der zweiten Streckenführung aktiviert oder beide Fahrzeugführungselemente sind an der jeweiligen Streckenführung aktiviert.

Bei einer Weiche mit einer Anordnung nach der Erfindung ist mindestens eine der beiden Strecken als eine derartige Linearmotorstrecke entlang des Fahrweges ausgebildet. Die zweite Strecke kann entlang des Fahrweges aus einem Linearmotorsystem oder einem reinen Führungssystem bestehen. Beide Strecken der Fahrwege weisen bevorzugt die erfindungsgemäßen Merkmale zur Steuerung - also zur Aktivierung oder Aufhebung - des Führungssystems auf.

Mittels der Steuerung des Führungssystems kann das Trägerfahrzeug den Fahrweg und ggf. das Linearmotorsystem wechseln.

Die Steuerung erfolgt beispielsweise mittels versenkbarer oder verstellbarer Fahrzeugführungselemente.

Eine vorteilhafte Weiterbildung sieht ein Computerimplementiertes Verfahren zur Simulation einer Maschine nach der Erfindung oder einer ihrer Weiterbildungen vor. Hierzu wird bevorzugt ein Computersystem umfassend mindestens einen Computer ausgebildet und vorbereitet zur Simulation gemäß dem Verfahren benutzt. Der Computer oder das Computersystem kann vorteilhaft mittels eines entsprechenden Computerprogrammprodukts zur Durchführung eines Verfahrens nach der Erfindung oder einer ihrer Weiterbildungen hierfür vorbereitet sein.

Im Folgenden ist die Erfindung anhand spezieller Ausführungsbeispiele zur Verdeutlichung näher beschrieben. Es zeigen:
- Figur 1: eine schematische Draufsicht auf Fahrwege im Bereich eines Weichenabschnitts mit einer Anordnung nach der Erfindung,
- Figur 2: eine schematische, vereinfachte Querschnitts-Darstellung einer Anordnung nach der Erfindung,
- Figur 3: eine schematische, vereinfachte Querschnitts-Darstellung einer alternativen Anordnung nach der Erfindung,
- Figur 4: eine schematische, vereinfachte dreidimensionale Darstellung eines Details IV aus Figur 3.
- Figur 5: eine schematische Darstellung einer auf einem Computer ablaufenden Simulation des Betriebes einer Induktivität nach der Erfindung, Computerprogrammprodukt.

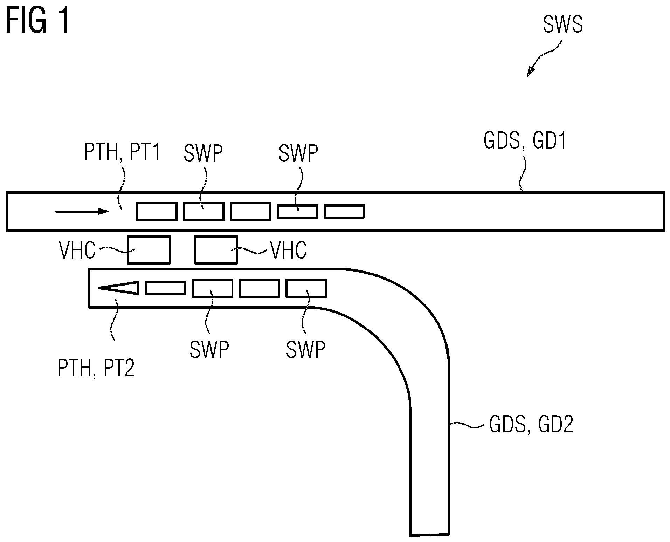

Die Figur 1 zeigt eine schematische Draufsicht auf zwei Fahrwege PTH im Bereich eines Weichenabschnitts SWS mit einer Anordnung ARR nach der Erfindung. Ein Führungssystem GDS für Trägerfahrzeuge VHC erstreckt sich entlang eines ersten Fahrweges PT1 als eine erste Streckenführung GD1.

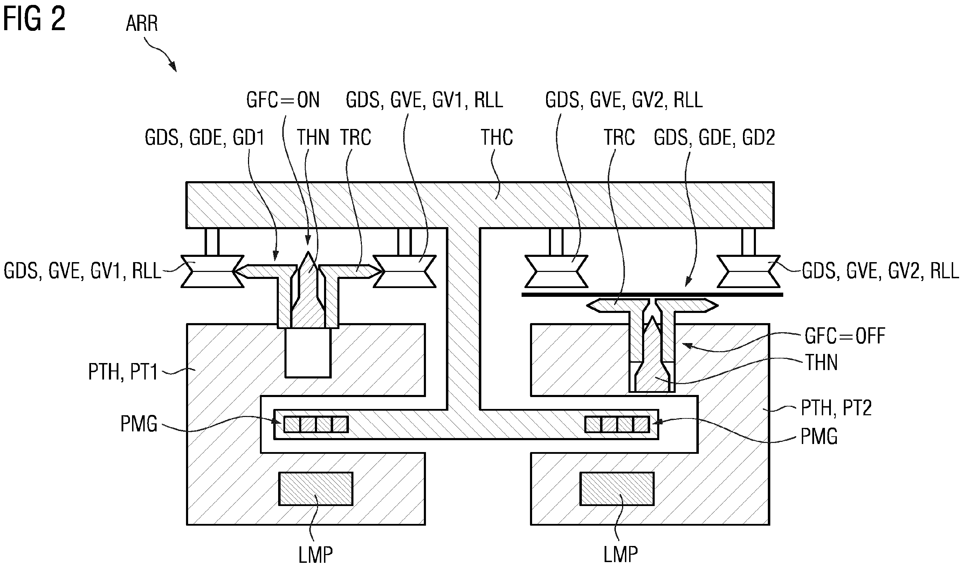

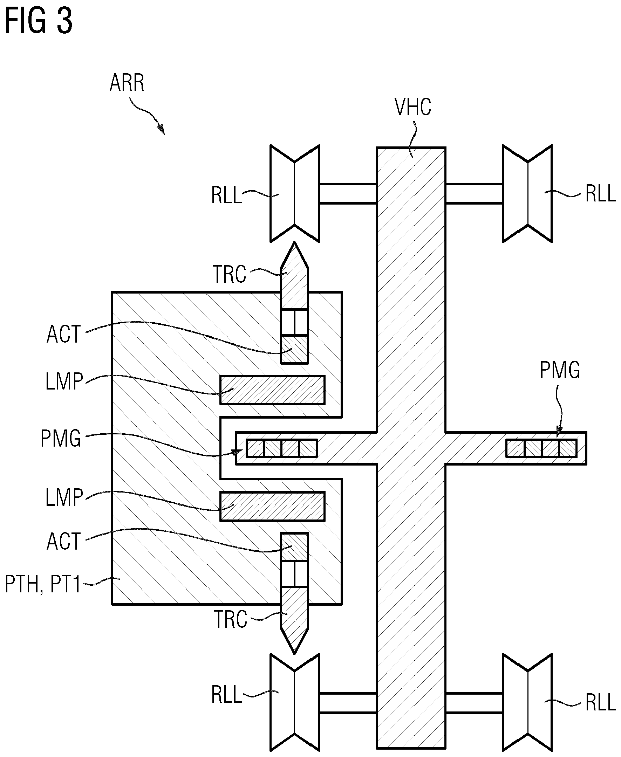

In den Figuren 2, 3 ist jeweils eine Anordnung ARR detaillierter im Querschnitt durch das Trägerfahrzeuge VHC und die Führungssysteme GDS der beiden Streckenführungen GDE entlang der Fahrwege PTH gezeigt.

Die Anordnung ARR umfasst ein Führungssystem GDS und ein Trägerfahrzeug VHC. Das Führungssystem GDS umfasst jeweils eine Streckenführung GDE für jeden Fahrweg PTH und Fahrzeugführungselemente GVE für jeden Fahrweg PTH an jedem Trägerfahrzeug VHC.

Das Führungssystem GDS weist an dem Trägerfahrzeug VHC Fahrzeugführungselemente GVE auf. Das Führungssystem GDS ist derart ausgebildet ist, dass eine Führungsfunktion GFC des Führungssystems GDS den Freiheitsgrad der translatorischen Beweglichkeit des Trägerfahrzeugs VHC beim Zusammenwirken der Streckenführung GDE mit den Fahrzeugführungselementen GVE bis auf ein begrenztes Bewegungsspiel auf eine translatorische Beweglichkeit entlang des Fahrweges PTH einschränkt.

Die Führungsfunktion GFC kann zumindest abschnittsweise entlang des Fahrweges PTH aufgehoben werden (GFC=OFF) oder aktiviert werden (GFC=ON). Dies kann grundsätzlich mittels einer Beweglichkeit der Fahrzeugführungselemente GVE und/oder der Streckenführung GDE realisiert sein. In den Figuren 2, 3 ist gezeigt, wie die Beweglichkeit der Streckenführung GDE ein Aktivieren (GFC=ON) oder Aufheben (GFC=OFF) der Führungsfunktion GFC ermöglicht.

Die Figuren 2, 3 zeigen das Führungssystem GDS der Anordnung ARR jeweils zweifach im Bereich eines Weichenabschnitts SWS. Das Führungssystem GDS weist hierbei eine sich entlang eines ersten Fahrweges PT1 erstreckende erste Streckenführung GD1 und eine sich entlang eines zweiten Fahrweges PT2 erstreckende zweite Streckenführung GD2 für das Trägerfahrzeug VHC auf.

Das Trägerfahrzeug VHC weist erste Fahrzeugführungselemente GV1 für die erste Streckenführungen GD1 und zweite Fahrzeugführungselemente GV2 für die zweite Streckenführung GD2 auf. Die beiden Streckenführungen GD1, GD2 und Fahrzeugführungselemente GV1, GV2 sind derart angeordnet, dass die Fahrwege PT1, PT2 des Trägerfahrzeugs VHC entlang des Weichenabschnitts SWS gleich sind.

Entlang der Fahrwege PT1, PT2 ist jeweils eine Linearmotorstrecke LMP ausgebildet ist, die mit an dem Trägerfahrzeug VHC angebrachten Magneten PMG magnetisch wechselwirkt. Auf diese Weise ist das Trägerfahrzeug VHC entlang des jeweiligen Fahrweges PTH antreibbar. Im Weichenabschnitt SWS ist es für den Antrieb ausreichend, wenn nur ein Fahrweg PT1, PT2 als Linearmotorstrecke LMP ausgebildet ist.

Bei einer Übergabe eines Trägerfahrzeugs VHC von einem Fahrweges PTH zu einem anderen in einem Weichenabschnitt SWS ist es kennzeichnend, dass das mechanische Führungssystem GDS beider Fahrwege PTH im Eingriff sein kann und dauerhaft das Führungssystem GDS mindestens eines Fahrweges PTH im Eingriff sein sollte. Zeitweise kann das Führungssystem GDS beider Fahrwege PTH im Eingriff sein.

Eine Abfolge für einen Wechsel des Fahrwegs PTH im Weichenabschnitt SRS kann in den Schritten erfolgen:
1. Das Trägerfahrzeug VHC bewegt sich entlang des ersten Fahrwegs PT1 in einen Weichenabschnitt SWS,
2. Führungsfunktion GFC für den zweiten Fahrweg PT2 aktivieren, so dass beide Führungsfunktionen GFC aktiv sind.
3. Führungsfunktion GFC für den ersten Fahrweg PT1 aufheben,
4. Weiterfahrt des Trägerfahrzeug VHC entlang des zweiten Fahrwegs PT2.
5. Sobald das Trägerfahrzeug VHC den Weichenabschnitt SWS verlassen hat, kann das nächste Trägerfahrzeug VHC dort einfahren.

Figur 2 zeigt mittels mehrerer entlang des Weichenabschnitts SWS elektromechanisch steuerbarer Dorne THN, die zwischen spreizbare als zwei gegenüberliegende Schienen TRC ausgebildete Streckenführungen GDE einrücken oder ausrücken, die wahlweise in als Rollen RLL ausgebildete Fahrzeugführungselemente GVE eingreifen oder aushaken. Die gesteuerten Dorne THN spreizen nicht nur die Schienen TRC in die Führungsfunktion GFC sondern sorgen bei der Aufhebung der Führungsfunktion GFC auch für eine Entfernung der Schienen TRC aus dem Bereich der Rollen bzw. Fahrzeugführungselemente GVE. Ein elektromechanischer Antrieb der Dorne THN ist in der Figur 2 nicht dargestellt.

Figur 3 zeigt eine etwas einfachere Ausbildung der Anordnung ARR nach der Erfindung mit abschnittsweise versenkbaren Schienen TRC der Streckenführungen GDE. Aktuatoren ACT ermöglichen hier auf gegenüberliegenden Seiten die Schienen TRC den Rollen RLL anzunähern oder von diesen zu entfernen. Der Einfachheit wegen ist die Streckenführung GDE nur auf der linken Seite dargestellt.

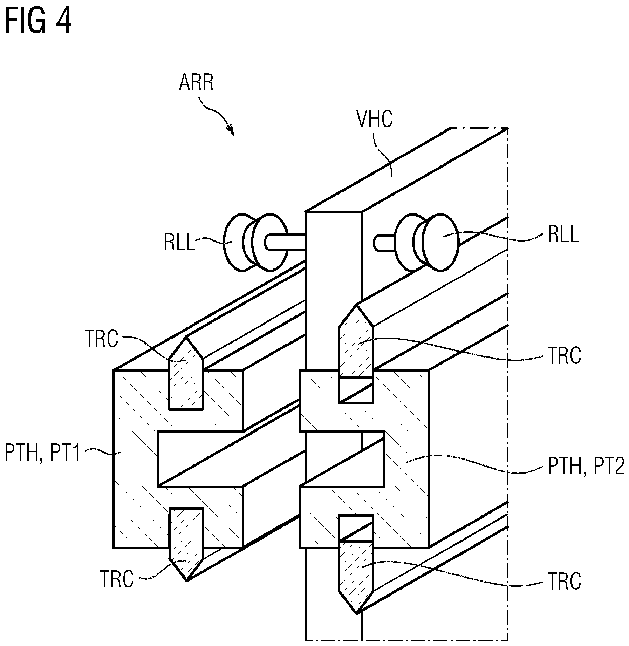

Zur Verdeutlichung der Erstreckung der Streckenführung GDE mit Schienen TRC entlang des Fahrwegs PTH zeigt Figur 4 die Streckenführung GDE und teilweise ein Trägerfahrzeugs VHC vereinfacht dreidimensional.

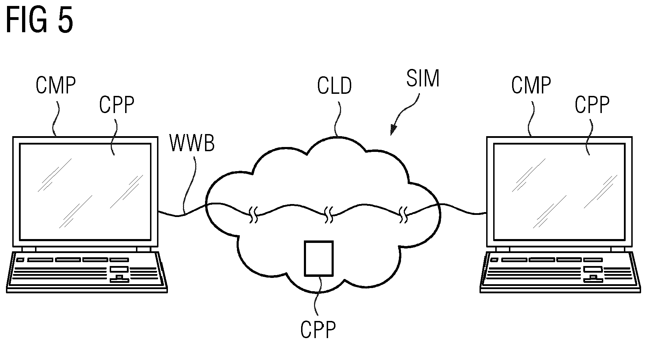

Figur 5 zeigt eine schematische Darstellung einer auf einem Computer CMP - hier auf mehreren Computern CMP eines Netzwerks WWB umfassend eine Cloud CLD - ablaufenden Simulation SIM der Anordnung ARR oder Weiche nach der Erfindung. Die auf den Computern CMP installierte Software ist ein Computerprogrammprodukt CPP, das bei Ausführung auf mindestens einem Computer CMP dem Benutzer mittels Schnittstellen, z.B. mittels Bildschirm und Tastatur eine Einflussnahme bzw. Konfiguration und einen Erkenntnisgewinn auf Basis der ausgeführten Simulation SIM ermöglicht, so dass insbesondere technische Gestaltungsentscheidungen mittels der Simulation unterstützt und verifiziert werden können.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

## Patentansprüche

1. Anordnung (ARR) umfassend
ein Führungssystem (GDS),
ein Trägerfahrzeug (VHC),
wobei das Führungssystem (GDS) eine sich entlang eines Fahrweges (PTH) erstreckende Streckenführung (GDE) für das Trägerfahrzeug (VHC) aufweist,
wobei das Führungssystem (GDS) an dem Trägerfahrzeug (VHC) Fahrzeugführungselemente (GVE) aufweist,
**dadurch gekennzeichnet, dass**
das Führungssystem (GDS) derart ausgebildet ist, dass
- eine Führungsfunktion (GFC) des Führungssystems (GDS) den Freiheitsgrad der translatorischen Beweglichkeit des Trägerfahrzeugs (VHC) beim Zusammenwirken der Streckenführung (GDE) mit den Fahrzeugführungselementen (GVE) bis auf ein begrenztes Bewegungsspiel auf eine translatorische Beweglichkeit entlang des Fahrweges (PTH) einschränkt,
- die Führungsfunktion (GFC) zumindest abschnittsweise entlang des Fahrweges (PTH)
(c) aufgehoben werden kann mittels einer Beweglichkeit der Fahrzeugführungselemente (GVE) und/oder der Streckenführung (GDE) aus einer Führungsposition heraus und
(d) aktiviert werden kann mittels einer Beweglichkeit der Fahrzeugführungselemente (GVE) oder der Streckenführung (GDE) in die Führungsposition hinein.

2. Anordnung (ARR) nach Anspruch 1, wobei entlang des Fahrweges (PTH) eine Linearmotorstrecke (LMP) ausgebildet ist, die mit an dem Trägerfahrzeug (VHC) angebrachten Magneten magnetisch wechselwirkt, so dass dadurch das Trägerfahrzeug (VHC) entlang des Fahrweges (PTH) antreibbar ist.

3. Anordnung (ARR) nach Anspruch 1 oder 2, wobei das Führungssystem (GDS) ein mechanisches Führungssystem (GDS) ist.

4. Anordnung (ARR) nach einem der vorhergehenden Ansprüche, wobei, die Fahrzeugführungselemente (GVE) mindestens eine, bevorzugt zwei Rollen (RLL) und die Streckenführung (GDE) mindestens eine, bevorzugt zwei Schienen (TRC) aufweisen.

5. Anordnung (ARR) nach einem der vorhergehenden Ansprüche, wobei die Aktivierung oder Aufhebung der Führungsfunktion mittels einer Beweglichkeit der Streckenführung (GDE) erfolgt.

6. Anordnung (ARR) nach einem der vorhergehenden Ansprüche, wobei die Streckenführung (GDE) zumindest abschnittsweise, insbesondere in einem Weichenabschnitt (SWS) quer zum Fahrweg (PTH) zum Zweck der Aktivierung oder Aufhebung der Führungsfunktion (GFC) translatorisch beweglich ausgebildet ist.

7. Weiche mit einer Anordnung (ARR) nach einem der vorhergehenden Ansprüche, wobei das Führungssystem (GDS) eine sich entlang eines ersten Fahrweges (PT1) erstreckende erste Streckenführung (GD1) und eine sich entlang eines zweiten Fahrweges (PT2) erstreckende zweite Streckenführung (GD2) für das Trägerfahrzeug (VHC) aufweist, wobei das Trägerfahrzeug (VHC) erste Fahrzeugführungselemente (GV1) für die erste Streckenführungen (GD1) und zweite Fahrzeugführungselemente (GV2) für die zweite Streckenführung (GD2) aufweist, wobei die beiden Streckenführungen (GD1, GD2) und Fahrzeugführungselemente (GV1, GV2) derart angeordnet sind, dass die Fahrwege (PT1, PT2) des Trägerfahrzeugs (VHC) entlang eines Weichenabschnitts (SWS) gleich sind.

8. Verfahren zur Übergabe eines Trägerfahrzeug (VHC) mittels einer Anordnung (ARR) oder einer Weiche (SWS) nach mindestens einem der vorhergehenden Ansprüche von einer ersten Streckenführung (GD1) entlang eines ersten Fahrwegs (PT1) an eine zweite Streckenführung (GD1) entlang eines zweiten Fahrweges (PT2),
wobei während der Übergabe stets die Führungsfunktion (GFC) entweder mittels der ersten Fahrzeugführungselemente (GV1) an der ersten Streckenführung (GD1) oder mittels der zweiten Fahrzeugführungselemente (GV2) an der zweiten Streckenführung (GD2) aktiviert ist oder beide Fahrzeugführungselemente (GV1, GV2) an der jeweiligen Streckenführung (GD1, GD2) aktiviert sind.

9. Computerimplementiertes Verfahren zur Simulation (SIM) einer Anordnung (ARR) oder einer Weiche (SWS) oder eines Verfahrens nach mindestens einem der vorhergehenden Ansprüche.

10. Computersystem (CPS) umfassend mindestens einen Computer (CMP) ausgebildet und vorbereitet zur Simulation gemäß dem Verfahren nach Anspruche 9.

11. Computerprogrammprodukt zur Durchführung eines Verfahrens nach Anspruch 9 mittels eines Computersystems (CPS) nach Anspruch 10.
